# EUROPEAN PATENT APPLICATION

(11) **EP 4 703 889 A1**
(43) Date of publication of application: **04.03.2026**
(21) Application number: 25199105.5
(22) Date of filing: 29.08.2025
(51) Int. Cl.: G06F 11/16, G06F 11/14

(54) **MEMORY CONTROLLER AND MCU CHIP**

(30) Priority: 29.08.2024 CN 202411205096
(71) Applicant: GigaDevice Semiconductor Inc., Haidian, Beijing (CN)
(72) Inventor: GAO, Yang, Haidian, Beijing (CN); WANG, Nanfei, Haidian, Beijing (CN)
(74) Representative: dompatent

(57) **Abstract**

A memory controller and an MCU chip are disclosed. The memory controller adds a second memory controller to a conventional memory controller architecture and is coupled to second NVM having first and second backup banks. In order to perform an OTA upgrade, one of the first and second backup banks of the second NVM is used as a default backup bank for supporting execution of an ongoing program of the system, and the other as an OTA upgrade backup bank for supporting OTA upgrade control.

## Description

### TECHNICAL FIELD

The present invention relates to the field of memory control, and more particularly to a memory controller and a microcontroller unit (MCU) chip.

### BACKGROUND

As microcontroller unit (MCU) chip technology evolves, more and more advanced process platforms have been developed for MCU design and production. The evolution of embedded flash (eFlash) memory, a common core MCU component, toward more advanced process nodes has gradually lagged behind the evolution of MCUs on such process platforms. Moreover, the operational mechanism, read and write speed and other aspects of eFlash memory are increasingly becoming limiting factors of high-end MCU performance. Therefore, new process platforms typically provide a variety of new non-volatile memory (NVM) to replace and upgrade eFlash memory from various aspects. Commonly used new NVMs include ferroelectric random-access memory (FeRAM), magnetic random-access memory (MRAM), resistive random-access memory (RRAM), phase-change memory (PCM), etc. They utilize different mechanisms to achieve non-volatile storage of data and typically provide better performance than eFlash memory. However, some of these new memories are not yet technically established, and the data storage mechanisms of some are susceptible to environmental factors. Therefore, many new NVMs are less reliable, compared with the established eFlash or NOR flash memory. That is, data stored in these new NVMs more tends to change, for example, due to perturbations from the outside world. Nevertheless, even when this happens, as the NVMs remain writable, such changes can be corrected by rewriting correct content into them.

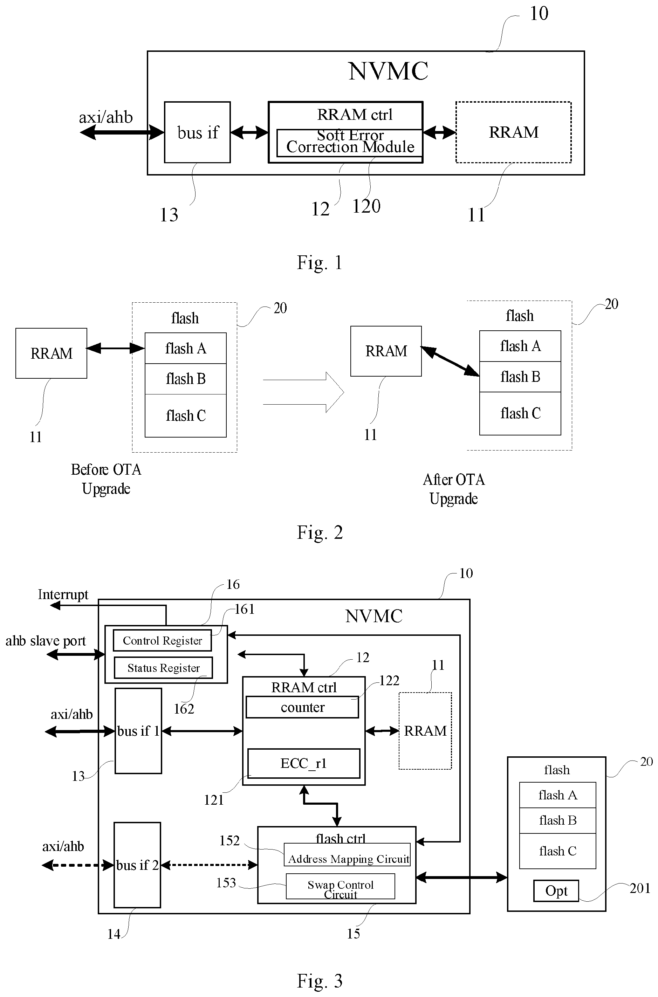

Taking RRAM as an example of such new NVMs, use of RRAM in an MCU is typically achieved by the structure shown in Fig. 1, in which it is arranged in an NVM controller (NVMC) and responsible for storage of content such as user-defined code. An RRAM controller Rram ctrl is responsible for read and write control of the RRAM, and a bus interface module bus _if is responsible for receiving data over a bus and converting it into a read operation on the RRAM. The bus may employ AXI, AHB or another bus protocol. Advanced MCU chips typically adopt an AXI interface. In view of low reliability of the RRAM, the conventional architecture usually employs an error checking and correction (ECC) function (e.g., single-bit error-correction, double-bit error detection (SEC-DED), double-bit error-correction, three-bit error detection (DEC-TED), etc.) for enhanced reliability. For example, if there is a single-bit error in data stored at an address of the RRAM, the ECC function can process the data to correct the error. However, when the data in the RRAM contains errors that exceed the error correction capability of the ECC function, the conventional NVMC architecture will not be able to obtain the correct data.

Further, many modern applications, especially those in the automotive and similar fields, are increasingly taking over the air (OTA) software upgrading as an important capability of MCU chips. OTA upgrading allows manufacturers to distribute firmware upgrading programs to chips in electronics over networks as a remedy for problems that have been found with the chips, which may otherwise necessitate expensive recalls. Therefore, MCU and other chips are required to provide enhanced OTA support.

Therefore, a novel NVMC architecture and NVMC chip are needed, which can fully leverage the fast read speed of the first NVM while also enabling OTA upgrade functionality.

### SUMMARY OF THE INVENTION

It is an object of the present invention to provide a memory controller, which can reduce the cost of an MCU chip, as well as such an MCU chip.

To this end, the present invention provides a memory controller coupled to a second non-volatile memory (NVM), wherein the second NVM comprises a first backup bank and a second backup bank, wherein one of the first and second backup banks is a default backup bank, and the other is an over the air (OTA) upgrade backup bank, and wherein the memory controller comprises:
a first NVM, wherein the first NVM allows faster read and write operations than the second NVM and serves as a main memory for storing content that is necessary for operation of a system, and wherein content of the first NVM has been backed up to the default backup bank of the second NVM;
a first memory controller responsible for a read and write control of the first NVM; and
a second memory controller, wherein the second memory controller is coupled to the first memory controller and is configured to: in preparation for performing an OTA upgrade, program content of an OTA upgrade version into the OTA upgrade backup bank; after a power-on reset (POR) or a system reset and when detecting that the content of the OTA upgrade version in the OTA upgrade backup bank is valid, initiate an OTA upgrading phase and copy the content of the OTA upgrade version from the OTA upgrade backup bank to the first NVM, thereby completing the OTA upgrade; and when the copying succeeds, update the OTA upgrade backup bank as the default backup bank and update a previous default backup bank as the OTA upgrade backup bank for use of next OTA upgrade.

The memory controller of the present invention adds the second memory controller to a conventional memory controller architecture and is coupled to the second NVM. Content in the first NVM is backed up to the default backup bank of the second NVM. In order to perform an OTA upgrade, one of the first and second backup banks of the second NVM can be used as the default backup bank for supporting execution of an ongoing program of the system, and the other can be used as an OTA upgrade backup bank for supporting OTA upgrade control. With this arrangement, one more memory access path is established, which takes full advantage of the fast reading characteristics of the first NVM and supports OTA upgrading without interrupting the execution of an ongoing program of the system.

Optionally, the memory controller may further comprise:
an OTA upgrade flag (fw_update) configured to: indicate whether the content of the OTA upgrade version has been written to the OTA upgrade backup bank, if yes, the OTA upgrade flag is valid; and if not or after the content of the OTA upgrade version has been successfully copied from the OTA upgrade backup bank to the first NVM, the OTA upgrade flag is invalid; and/or
a backup bank mapping control flag (SWAP) configured to indicate which one of the first and second backup banks is designated as the default backup bank; and/or
an OTA upgrade success flag (ota_success) configured to indicate whether the OTA upgrade is successful.

In this way, the memory controller of the present invention supports OTA upgrading by using several flags. This approach is easy to implement and inexpensive.

Optionally, the memory controller may further comprise an OTA upgrade check flag (ota_check) and/or an OTA upgrade failure flag (ota_fail), wherein the OTA upgrade check flag is configured to indicate whether to perform a self-check in the OTA upgrading phase on the content of the OTA upgrade version that has been copied to the first NVM, and wherein the OTA upgrade failure flag is opposite or complementary to the OTA upgrade success flag and is configured to be used with the OTA upgrade success flag to indicate success or failure of the OTA upgrade.

Optionally, the OTA upgrade flag, the backup bank mapping control flag and the OTA upgrade check flag may be provided in an option byte or a control register and may not lose data in the event of a power loss, and the OTA upgrade failure flag and the OTA upgrade success flag may be provided in an ordinary control register and may lose data in the event of a power loss. In this way, these flags can be easily configured.

Optionally, the memory controller may further comprise:
a first bus interface, which is coupled to the first memory controller and a system bus and configured for transfer of content between the system bus and the first memory controller,
wherein when out of the OTA upgrading phase, the second memory controller is further configured to cooperate with the first memory controller to back up content in the first NVM to the default backup bank and, when any error is identified in content read from the first NVM, the second memory controller is further configured to read corresponding backup content from the default backup bank and transmit it to the system bus or write it to the first NVM for content repair.

Thus, in the memory controller of the present invention, the content of the first NVM in the memory controller is backed up to the second NVM out of the OTA upgrading phase. This allows full utilization of the fast reading characteristics of the first NVM. Additionally, once any error is identified in content read by the system bus from the first NVM, or any corrupted address is detected in the first NVM, the second memory controller can automatically read exactly corresponding backup content from the default backup bank of the second NVM and return it to the system bus (optionally via the first or second bus interface). Alternatively, the first NVM may be accurately repaired. This ensure that a central processing unit (CPU) or other master on the system bus reads correct content, while not interrupting an execution of ongoing program of the system.

Optionally, the second NVM may have a plurality of default backup banks each storing backup content of a different old version, wherein the second memory controller is further configured to, when the OTA upgrade fails, copy the backup content of a corresponding old version stored in a designated one of the default backup banks to the first NVM according to a rollback command issued in response to the failure of the OTA upgrade, or wherein the second NVM has another bank, wherein the first and second backup banks are configured to store backup content of respective versions, and wherein the another bank is configured to store other data than in the first NVM.

With this arrangement, once an OTA upgrade fails, the memory controller of the present invention allows the system to roll back to an old version, avoiding a crash or other issues that may otherwise arise from the OTA upgrade failure.

Optionally, the memory controller may further comprise a second bus interface, which is coupled to the second memory controller and the system bus and configured to, when out of an OTA upgrading phase, transmit backup content read by the second memory controller from the default backup bank to the system bus. With this arrangement, once any error is identified in content read by the system bus from the first NVM or any corrupted address is detected in the first NVM, the second memory controller can automatically read corresponding backup content from the default backup bank of the second NVM and return it to the system bus via the second bus interface, instead of via the first memory controller and the first bus interface. This shorter transmission path enables faster read operations.

Optionally, the memory controller may further comprise a control register coupled to the first memory controller, wherein the first memory controller is further configured to read and load an option byte into the control register following a system reset, thereby validating the option byte.

The option byte may be a special memory region in the first or second NVM and is configured to store configuration information.

With this arrangement, based on settings of the option byte, the memory controller of the present invention can provide appropriate handling strategies for different error conditions of the first NVM, addressing error handling needs of various users and applications.

Optionally, the second memory controller may be further configured to, upon the system bus reading any corrupted address in the first NVM set or recorded in the option byte or control register, automatically read corresponding backup content from the second NVM and return it to the system bus.

With this arrangement, when the memory controller of the present invention reads any corrupted address in the first NVM out of an OTA upgrading phase, depending on settings of the option byte, it can automatically repair or correct an error by ECC function, or automatically report corresponding backup content, or automatically skip the corrupted address. This ensures as much as possible that a CPU or other master on the system bus reads correct content, without interrupting the execution of an ongoing program of the system.

Optionally, the first memory controller may comprise a first soft error correction module, and wherein in case of being out of the OTA upgrading phase, when the system bus reads corresponding content from the first NVM, the first soft error correction module performs an error checking on the corresponding content in real time through an error checking and correction (ECC) function.

The first soft error correction module may be further configured to correct the error through the ECC function and to provide corrected content to the system bus when the error is detected by the ECC function and meets an error correction ability of the first soft error correction module; or
regardless of whether the configuration information pre-configures that the first NVM is to be repaired or not, the first soft error correction module is configured to correct the error through the ECC function and to provide corrected content to the system bus when the error is detected by the ECC function and meets the error correction ability of the first soft error correction module, and wherein when the memory controller becomes idle at a later time, the second memory controller is configured to read corresponding backup content from the default backup bank and to write the backup content to the first NVM for content repair.

With this arrangement, in the memory controller of the present invention, when out of an OTA upgrading phase, the first soft error correction module (which may be a single-bit error-correction, double-bit error detection (SEC-DED) or double-bit error-correction, three-bit error detection (DEC-TED) ECC module) can perform error checking on content from the first NVM, and can configure the option byte so that content in the default backup bank is to be used to repair the first NVM or not. Additionally, the first soft error correction module can correct errors of a small number of bits (e.g., 1-bit errors) by ECC function. Thus, real-time ECC is achievable to ensure correctness of content in the first NVM, resulting in time savings. Further, as ECC function can ensure correctness of content, the execution of a program of the system can be continued, but not interrupted.

Optionally, the first soft error correction module may be further configured to, during writing of content to the first NVM and/or during backing up of content in the first NVM to the default backup bank, generate a corresponding ECC code, which is stored in the default backup bank along with the content in the first NVM.

Alternatively, the second memory controller may further comprise a second soft error correction module configured to, during backing up of content in the first NVM to the default backup bank, generate a corresponding ECC code, which is stored in the default backup bank along with the content in the first NVM.

Additionally, as the system bus reads the content in the first NVM, the first soft error correction module may carry out an error checking on read content in real time through the ECC function using corresponding ECC code.

With this arrangement, the first soft error correction module can provide ECC protection to content written to the first NVM, and the first and/or second soft error correction modules can provide ECC protection to backup content written to the second NVM, increasing storage reliability of the first NVM and the second NVM.

Optionally, when the first soft error correction module detects any error meeting or exceeding its error correction ability during error checking and if the configuration information configures that the first NVM is to be repaired, the second memory controller may be further configured to read corresponding backup content from the default backup bank and write the read content to the first NVM for content repair.

With this arrangement, the memory controller of the present invention can configure the configuration information in the option byte so that the first NVM is to be repaired. Thus, backup content can be read from the second NVM and written to the first NVM for content repair. When the repair succeeds, execution of a program can be continued. This enables the system to operate with higher reliability and continuity.

Optionally, when out of an OTA upgrading phase, the second memory controller may read backup content in the default backup bank in a unit of a single address, or a single row address, or a single block of the first non-volatile memory according to the configuration information and write it to the first NVM for repair of the first NVM.

With this arrangement, the memory controller of the present invention can carry out repair at different increments, as required.

Optionally, the configuration information may set a threshold number of repeated repair attempts, wherein the second memory controller is allowed to make a number of repeated attempts to repair the first NVM with backup content from the second NVM, which does not exceed the threshold. With this arrangement, repeated repair attempts can be made to identify in time physically damaged addresses or blocks in the first NVM (containing errors which will fail to be repaired even when the number of repeated attempts that have been made reaches the threshold), and the threshold number of repeated repair attempts can prevent the system from entering an infinite loop. Moreover, when any physically damaged address or block is identified in the first NVM, the memory controller can automatically skip it and directly read backup content from the second NVM. This enables continued operation of the system and enhances its operational security.

Optionally, the memory controller may further comprise a status register configured to record: first status information about an result of ECC function performed on the first NVM when the configuration information configures that the first NVM is not to be repaired, which contains statuses and addresses of errors; and second status information about an result of repair performed on the first NVM when the configuration information configures that the first NVM is to be repaired, which contains at least one of statuses, addresses and the number of repair-failed errors and the number of repair failures. With this arrangement, information about an ECC and real-time repair result can be recorded in real time in the status register.

Optionally, the first or second memory controller may be further configured to record the addresses of the repair-failed errors in the first NVM in the status register, and wherein a software strategy determines whether to store the addresses of the repair-failed errors in the first NVM as damaged addresses in the configuration information of the option byte.

Optionally, the second memory controller may be further configured to, upon the system bus reading any of the corrupted addresses in the configuration information and/or any error address recorded in the status register, automatically skip the first NVM, read corresponding backup content from the default backup bank and return it onto the system bus.

With this arrangement, when reading the first NVM, the memory controller of the present invention can skip its corrupted addresses set in the option byte and/or previously-identified error addresses recorded in the status register and directly read backup content in the second NVM. This allows the system bus to obtain correct data in a shorter time and ensures as much as possible that a CPU or other master on the system bus reads correct content, without interrupting the execution of an ongoing program of system.

Optionally, the status register may be further configured to generate an interrupt based on record(s) therein. With this arrangement, based on the interrupt, a CPU or other master on the system bus can take an appropriate action at a later time.

Optionally, the first memory controller may further comprise a self-check module, wherein in preparation for performing the OTA upgrade and after the content of the OTA upgrade version is copied from the OTA upgrade backup bank to the first NVM, the self-check module is configured to perform a self-check on the content that is copied into the first NVM by reading and comparing the content in the first NVM with the content in the OTA upgrade backup bank, wherein if no difference is found in the comparison, the content in the first NVM is considered to be correct, or if a difference is identified in the comparison, the content in the first NVM is considered to contain an error. With this arrangement, the self-check module in the memory controller of the present invention can automatically check content in the first NVM in preparation for an OTA upgrade and apply ECC or real-time repair to any detected error, additionally ensuring OTA upgrading reliability and facilitate use by users.

Optionally, the first NVM may be embedded memory that does not require erasure before a write operation to be performed thereon, and the second NVM may be off-chip memory.

Optionally, the first NVM may comprise at least one of ferroelectric random-access memory (FeRAM), magnetic random-access memory (MRAM), resistive random-access memory (RRAM) and phase-change memory (PCM). Alternatively or additionally, the second NVM may comprise flash memory. With this arrangement, any of those types of memory can be embedded as the first NVM in an MCU chip on an advanced process platform, and the advantages of flash memory, including a large capacity, high reliability and ease of implementation on a single PCB with an MCU or of packaging within a single MCU package with an MCU die using a stack packaging technique can be leveraged to achieve a desired MCU architecture.

On the basis of the same inventive concept, the present invention also provides an MCU chip comprising a CPU and the memory controller as defined above. The CPU is coupled to the memory controller via a system bus in order to perform read and write operations on the first NVM in the memory controller. Second NVM is built in or externally connected to the MCU chip, and is coupled to the second memory controller in the memory controller.

As this MCU chip employs the memory controller of the present invention, it is much less likely to be interrupted due to errors in the content of the first NVM during startup or running of the system. Moreover, the system has improved reliability and performance.

### BRIEF DESCRIPTION OF THE DRAWINGS

Those of ordinary skill in the art would appreciate that the following drawings are presented to enable a better understanding of the present invention and do not limit the scope thereof in any sense, in which:
Fig. 1 is a schematic diagram illustrating the architecture of a conventional RRAM-based memory controller;
Fig. 2 schematically illustrates memory mappings before and after an OTA upgrade in the architecture of a memory controller according to a first embodiment of the present invention.
Fig. 3 is a schematic diagram illustrating the architecture of a specific example of the memory controller according to the first embodiment of the present invention.
Fig. 4 shows a table listing flags and their descriptions in the architecture of the memory controller according to the first embodiment of the present invention.
Fig. 5 is a flowchart of an OTA upgrade process performed by the memory controller according to the first embodiment of the present invention.
Fig. 6 is a schematic diagram illustrating the architecture of another specific example of the memory controller according to the first embodiment of the present invention.
Figs. 7A to 7C are flowcharts of three example read processes of the memory controller according to the first embodiment of the present invention.
Fig. 8 is a schematic diagram illustrating the architecture of a specific example of a memory controller according to a second embodiment of the present invention.
Fig. 9 shows a table listing flags and their descriptions in the architecture of the memory controller according to the second embodiment of the present invention.
Fig.10 is a flowchart of an OTA upgrade process performed by the memory controller according to the second embodiment of the present invention.
Fig. 11 is a flowchart of a self-check performed out of an OTA upgrading phase by the memory controller according to the second embodiment of the present invention.
Figs. 12A and 12B are schematic architecture diagrams of two specific examples of an MCU chip according to a third embodiment of the present invention.

### DETAILED DESCRIPTION

The following description sets forth numerous specific details in order to provide a more thorough understanding of the present invention. However, it will be apparent to those skilled in the art that the present invention can be practiced without one or more of these specific details. In other instances, well-known technical features have not been described in order to avoid unnecessary obscuring of the invention. It is understood that the invention may be embodied in many different forms and should not be construed as being limited to the embodiments set forth below. Rather, these embodiments are provided so that this disclosure is thorough and conveys the scope of the invention to those skilled in the art. In the drawings, same reference numerals refer to same elements throughout. It will be understood that when an element is referred to as being "connected to" or "coupled to" another element, it can be directly connected or coupled to the other element, or intervening elements may also be present. In contrast, when an element is referred to as being "directly connected to" another element, there are no intervening elements. As used herein, the singular forms "a", "an" and "the" are intended to include the plural forms as well, unless the context clearly indicates otherwise. It will be further understood that the term "comprising" specifies the presence of stated features, steps, operations, elements, and/or components, but do not preclude the presence or addition of one or more other features, steps, operations, elements, components, and/or groups thereof. As used herein, the term "and/or" includes any and all combinations of the associated listed items.

The present invention will be described in greater detail below with reference to the accompanying drawings, which illustrate specific embodiments thereof. From the following description, advantages and features of the present invention will become more apparent. Note that the figures are provided in a very simplified form not necessarily drawn to exact scale for the only purpose of helping to explain the disclosed embodiments in a more convenient and clearer way.

### Embodiment 1

Figs. 2 and 3 show a memory controller (NVMC) 10 according to an embodiment of the present invention, which is coupled to second NVM (e.g., flash memory) 20 and includes first NVM (e.g., RRAM) 11, a first memory controller (RRAM ctrl) 12, a first bus interface (bus if 1) 13, a second bus interface (bus if 2, optional) and a second memory controller (flash ctrl) 15.

The second NVM 20 may be off-chip or on-chip memory, and may be any suitable NVM such as flash memory. Compared with the first NVM 11, it may have the same or larger capacity, slower read and write speeds and higher reliability. The second NVM 20 may be implemented as a memory chip externally coupled to a chip (e.g., an MCU or other chip), in which the memory controller 10 is embodied, and these chips may be integrated on a single PCB. Alternatively, it may be implemented as a memory die, which is packaged within the same MCU package as an MCU diein which the memory controller 10 is embodied, using a system-in-a-package (SiP) approach (e.g., creating a SiP flash memory architecture).

Referring to Figs. 2 and 3, the second NVM 20 includes a first backup bank flash A and a second backup bank flash B. One of the first backup bank flash A and the second backup bank flash B is a default backup bank, and the other is an over the air (OTA) upgrade backup bank. The default backup bank is configured to store a backup of the content of the first NVM 11 (including code, data, etc.). The second memory controller 15 is configured to program the content of an OTA upgrade version (e.g., in the form of a firmware program, code or the like) into the OTA upgrade backup bank. Moreover, after a power-on reset (POR) or system reset and detecting that the content of the OTA upgrade version in the OTA upgrade backup bank is valid, it initiates an OTA upgrading phase and copies the content of the OTA upgrade version from the OTA upgrade backup bank into the first NVM 11, completing the OTA upgrade. When the copying succeeds, it updates the OTA upgrade backup bank as a default backup bank, and the previous default backup bank as an OTA upgrade backup bank to be used in the next OTA upgrade.

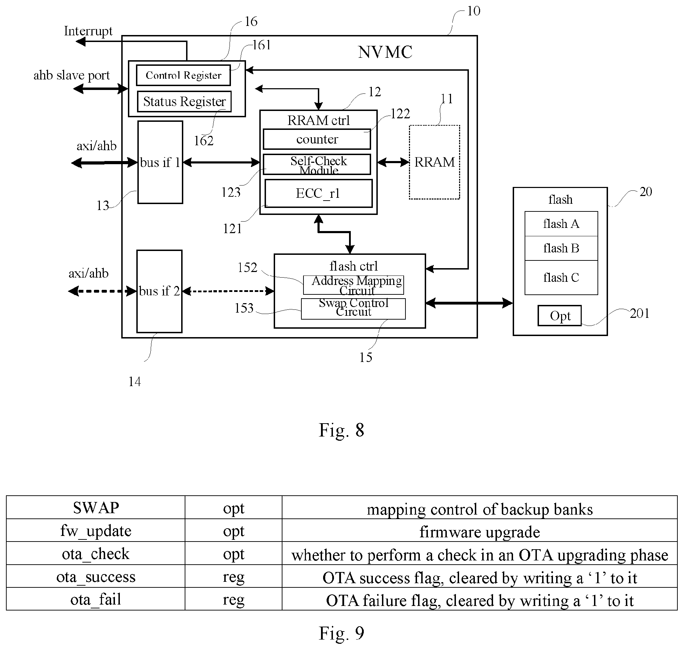

The first NVM 11 is embedded NVM and does not need to be erased before new data is written into it. It may be implemented as any suitable one or more embedded memory arrays, such as ferroelectric random-access memory (FeRAM), magnetic random-access memory (MRAM), resistive random-access memory (RRAM) and/or phase-change memory (PCM). It can be used for non-volatile storage of content (e.g., code, data, etc.). For example, the first NVM 11 may be fabricated, together with a central processing unit (CPU) core of an MCU chip (e.g., 30 of Fig. 9), on a platform of an advanced process node, thereby avoiding limiting the evolution and performance of the MCU chip on the platform. In this case, the first NVM 11 allows faster read and write operations than the second NVM 20 and serves as main memory supporting execution of programs by the MCU chip. Accordingly, it may store content (e.g., code, data, etc.) necessary for the running of a system of the MCU chip. This allows the system to provide improved performance. Further, the first NVM 11 may logically belong to the memory controller 10 but be physically separate therefrom. That is, the first NVM 11 may be physically arranged outside the memory controller 10 and is accordingly represented by a "dashed box" drawn inside a diagrammatic representation of the memory controller 10 in the annexed figures. In contrast, each of the first memory controller (RRAM ctrl) 12, the first bus interface (bus if 1) 13 and the second bus interface (bus if 2, optional) 14, which are all physically arranged within the memory controller 10, is represented by a "solid box" drawn inside the diagrammatic representation of the memory controller 10.

FeRAM, MRAM, RRAM and PCM employ different mechanisms to achieve non-volatile storage of data. Specifically, FeRAM utilizes the ferroelectricity of ferroelectric crystals to store data. Ferroelectricity is a property of a ferroelectric crystal that a central atom in the crystal moves in a stable pattern when an electric field is applied thereto. After the electric field is removed from the crystal, the center atom will remain at the original position. Therefore, '1'or '0'can be stored in FeRAM simply by applying electric fields in corresponding directions to change states in the ferroelectric crystals. FeRAM features fast read and write operations, low power consumption and needlessness of a data retention voltage and of being periodically refreshed like DRAM. MRAM leverages magnetoresistance to achieve storage of data. Specifically, magnetic tunnel junctions (MTJs) are used as MRAM cells, which can be magnetized in different directions to store '1' and '0'. RRAM features a very simple structure consisting of a metal oxide film sandwiched by electrodes. When a pulse voltage is applied across the electrodes, the film will experience a considerable resistance change, which can be used to store '1' and '0'. PCM contains a phase-change material, which can transitions between crystalline and amorphous states, and utilizes different conductivity values of the material in the different states to store '1' and '0'.

Unlike flash memory, FeRAM, MRAM, RRAM and PCM need not be erased before new data is written therein. Therefore, when the first NVM 11 is implemented as any of FeRAM, MRAM, RRAM and PCM, if any error is detected in the content of the first NVM 11, it can be corrected simply by exactly overwriting it with corresponding backup content read from the second NVM 20.

The first memory controller 12 is responsible for read and write control of the first NVM 11. The first bus interface 13 is coupled to the first memory controller 12 and a system bus (which may employ the AXI, AHB or other bus protocols) and is configured to transfer content between the system bus and the first memory controller 12. That is, in the present embodiment, the memory controller 10 can be connected to the system bus via the first bus interface 13.

The second memory controller 15 is responsible for read and write control of the second NVM 20. Specifically, the second memory controller 15 is coupled to the first memory controller 12 and is configured to, when out of an OTA upgrading phase, work with the first memory controller 12 to back up the content of the first NVM 11 into the default backup bank of the second NVM 20. Moreover, when any error is identified in content read from the first NVM 11 by the system bus, corresponding backup content is read from the default backup bank of the second NVM 20 according to configuration information and written into the first NVM 11 by the first memory controller 12 for content repair. Alternatively, the read backup content is transmitted by the first memory controller 12 through the first bus interface 13 or the second bus interface 14 onto the system bus and thus to the CPU core or another master on the system bus, thereby obtaining correct content (e.g., code, data, etc.)

The second memory controller 15 is also configured to program the content of the OTA upgrade version into the OTA upgrade backup bank of the second NVM 20, in preparation for an OTA upgrade. Moreover, when the content of the OTA upgrade version in the OTA upgrade backup bank is detected to be valid following a POR or system reset, it is configured to initiate an OTA upgrading phase and copy the content of the OTA upgrade version from the OTA upgrade backup bank into the first NVM 11, completing the OTA upgrade. When the copying succeeds, the OTA upgrade backup bank is updated as a default backup bank, and the previous default backup bank is updated as an OTA upgrade backup bank to be used in the next OTA upgrade.

As an example, referring to Figs. 2 and 3, the second NVM 20 is NOR flash memory, and the first NVM 11 is RRAM. The NOR flash memory (i.e., the second NVM 20) has a greater capacity than the RRAM (i.e., the first NVM 11) and includes a first backup bank flash A, a second backup bank flash B and another storage bank flash C. One of the first backup bank flash A and the second backup bank flash B is a default backup bank, and the other is an OTA upgrade backup bank. The first backup bank flash A and the second backup bank flash B correspond to the RRAM. That is to say, logical address ranges of the first backup bank flash A and the second backup bank flash B are mapped to logical address ranges of the RRAM (i.e., the first NVM 11). The default backup bank is configured to store a backup of the content of the RRAM (i.e., the first NVM 11), and the other storage bank flash C of the NOR flash memory (i.e., the second NVM 20) may serve functions like data flash for storage of data outside the logical address ranges of the RRAM.

In this embodiment, when out of an OTA upgrading phase (i.e., prior to the upcoming OTA upgrade), there is an address mapping between the default backup bank flash A and the RRAM, and the default backup bank *flash A* stores a backup of the content of the RRAM before the upcoming OTA upgrade. When any error is identified in content read from the RRAM by the system bus, if required, correct backup content can be read from flash A by the second memory controller 15 and written into the RRAM by the first memory controller 11 to correct the error in the RRAM. This process is described in greater detail below and no further description thereof is set forth here. During OTA upgrading, the content of the OTA upgrade version can be programmed (i.e., written) into the OTA upgrade backup bank flash B following the path: first bus interface 13 -> first memory controller 11 -> second memory controller 15 -> flash B. Upon a POR or system reset, the content of the OTA upgrade version is read by the second memory controller 15 from flash B and written by the first memory controller 12 into the RRAM to overwrite the content of the old version in the RRAM. When the copying succeeds, flash B is updated as a default backup bank, and flash A is updated as an OTA upgrade backup bank. In this way, flash B that stores the content of the OTA upgrade version can directly serve as a new backup bank for the RRAM, without requiring backing up new content from the RRAM to the flash B, and the content of the next OTA upgrade version can be written into flash A. Further, during the programming of the content of the OTA upgrade version into flash B, as a system's current program being executed by the system runs on the RRAM and because error correction is performed on the RRAM using the content of flash A, it is not necessary to interrupt the ongoing program.

It will be understood that, in this embodiment, flash A, flash B and flash C have fixed addresses. For example, a base (or start) address of flash A may be 1000, and a base (or start) address of flash B may be 3000. Moreover, flash A and flash B may have the same address offsets, which correspond to respective address offsets of the RRAM. Therefore, after the OTA upgrade is completed, the default backup bank flash A and the OTA upgrade backup bank flash B may be swapped by altering the address mapping between flash A, flash B to the RRAM.

Therefore, the memory controller of the present embodiment is obtained by adding, to the memory controller architecture of Fig. 1, a memory access path by additionally providing the second memory controller 15 and coupling it to the second NVM 20. When out of an OTA upgrading phase, the second NVM stores a backup of the content of the first NVM. Once the system bus identifies any error in content read from the first NVM, or a problematic address in the first NVM, the second memory controller 15 can automatically read exactly corresponding backup content from the second NVM 20 and provide it on the system bus, or use it to accurately correct the error in the first NVM 11. This ensures that the content read by the central processing unit (CPU) or another master on the system bus is correct, without interrupting a program being executed by the system. During OTA upgrading, one of the first and second backup banks of the second NVM can be used as a default backup bank for the first NVM to support the execution of a current program of the system, and the other as an over the air (OTA) upgrade backup bank for the first NVM to support OTA upgrade control. In this way, during OTA upgrading, it is also unnecessary to interrupt the execution of the current program of the system.

It will be understood that any suitable hardware necessary for carrying out an OTA upgrade can be added to the memory controller 10 of this embodiment.

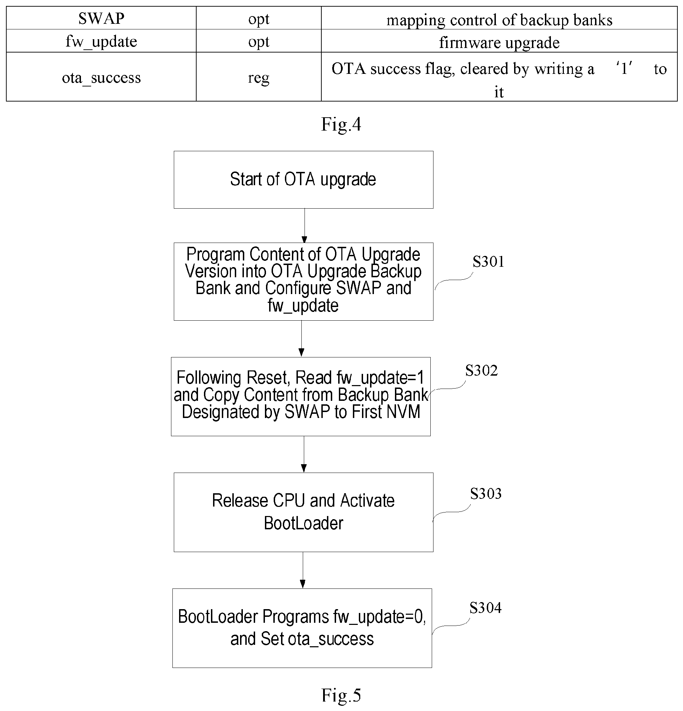

For example, referring to Fig. 4, the memory controller 10 of this embodiment may further include at least one of an OTA upgrade flag fw_update, a backup bank mapping control flag SWAP and an OTA upgrade success flag ota_success.

The OTA upgrade flag fw_update is configured to indicate whether the content of an OTA upgrade version has been written in the OTA upgrade backup bank (e.g., flash B). If yes, the OTA upgrade flag fw_update may be programmed (or set) to a valid value (e.g., fw_update=1). Consequently, the OTA upgrade flag fw_update is valid, allowing the CPU to run the content of the OTA upgrade version. If not, or after the content of the OTA upgrade version has been successfully copied from the OTA upgrade backup bank (e.g., flash B) into the first NVM 11, the OTA upgrade flag fw_update may be programmed (or set) to an invalid value (e.g., fw_update=0). Consequently, the OTA upgrade flag is invalid, allowing the content of an OTA upgrade version to be written in subsequent operations.

The backup bank mapping control flag SWAP is configured to indicate which one of the first backup bank flash A and the second backup bank flash B is the default backup bank for the first NVM 11.

The OTA upgrade success flag ota_success is configured to indicate whether an OTA upgrade is successful, i.e., whether the CPU has successfully run the content of an OTA upgrade version. If yes, ota_success is cleared by writing a '1' to it.

Further, fw_update and SWAP may be both single bits in a special control register 161 for loading an option byte. This enables them not to lose the data stored thereon in the event of a power loss. Ota_success may be a single bit in an ordinary control register (not shown) different from the control register 161 and therefore will lose the data stored thereon when power is lost.

Accordingly, in this case, the memory controller 10 of the present embodiment may include a register bank 16 including the special control register 161 and the ordinary control register different from the control register 161. The control register 161 may serve mainly for control of OTA upgrading and real-time repair functions, and may be coupled to the first memory controller 12. When a system reset occurs, the first memory controller 12 may read and load configuration information of the option byte (Opt) into the control register 161, thereby validating the option byte. The ota_success may be configured in the ordinary control register, and the fw_update and SWAP may be configured in the control register 161.

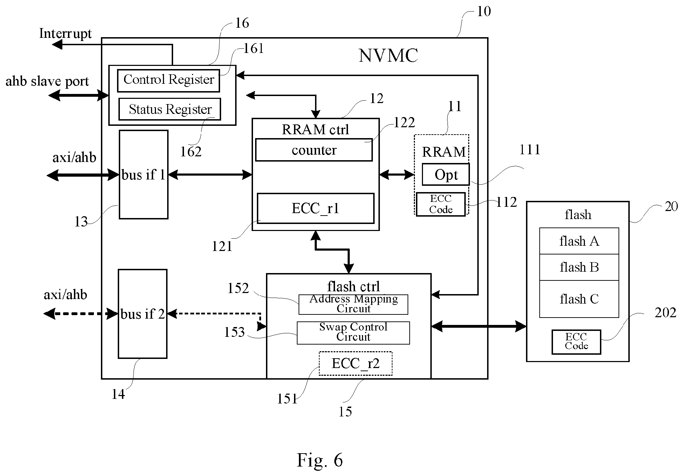

The option bytes (Opt) can be a specific storage area in the first NVM 11 (as shown by Opt 111 in Fig.6) and are used to store configuration information required by the system. Alternatively, the option bytes (Opt) can be a specific storage area in the second NVM 20 (as shown by Opt 201 in Fig.3) and are used to store relevant configuration information for the system. The configuration information of the option byte may comprise configuration information that is predefined by the system and that is updated based on ECC correction records of the first NVM 11 and real-time repair records according to a software strategy of the system. The configuration information can determine whether to carry out an OTA upgrade by the memory controller, whether to repair the first NVM 11, etc.

Therefore, the memory controller of the present embodiment can use the several flags to support OTA upgrading in an easy-to-implement, low-cost manner. When out of an OTA upgrading phase, an appropriate handling strategy may be formulated or selected for different error conditions of the first NVM 11 according to configuration information stored in the option byte. Once the system is reset, the memory controller 10 may first read the configuration information in the option byte from the first NVM 11 or the second NVM 20 and load the configuration information read from corresponding option byte into the control register 161 in the memory controller 10, thereby validating the configuration information in the option byte. In this way, various error handling needs of different users and applications can be addressed.

It will be understood that the control register 161 is not limited to being only readable or both readable and writable by the CPU, or being implemented as a single register. Instead, it may be a register bank consisting of multiple registers (e.g., including a corrupted address register, a count threshold register, a selection register indicative of a selection of whether to conduct repair, etc.) The present invention is not particularly limited in any sense in this regard.

As another example, referring to Fig. 3, in the memory controller 10 of the present embodiment, the second memory controller 15 may include an address mapping circuit 152 and a swap control circuit 153. The address mapping circuit 152 is configured to establish a physical address mapping between the first NVM 11 and the first or second backup bank flash A or B. For example, referring to Fig. 2, the address mapping circuit 152 may, by default, establish a mapping between physical addresses of the first NVM 11 and the first backup bank flash A. The swap control circuit 153 is configured to control the address mapping circuit 152 to update the physical address mapping between the first NVM 11 and the first or second backup bank flash A or B, according to the backup bank mapping control flag SWAP.

Referring to Figs. 2 to 5, a process performed by the memory controller 10 of the present embodiment to carry out an OTA upgrade includes the steps described below.

In S301, the default backup bank is flash A, and the OTA upgrade backup bank is flash B. The second memory controller 15 programs (or writes) the content of an OTA upgrade version (e.g., an updated firmware program) into flash B (i.e., the current OTA upgrade backup bank). The second or first memory controller 15 or 12 sets SWAP to a valid value (e.g., SWAP=1, indicating that flash B is to be subsequently updated as a default backup bank) and fw_update to a valid value (e.g., fw_update=1), in the control register 161. In this process, as the software program runs on the first NVM 11, even when any error is found in the content of the first NVM 11, it can be ECC corrected or repaired with backup content from flash A, it is unnecessary to interrupt the execution of the ongoing program.

In S302, a POR or system reset occurs, and the first memory controller 12 identifies the validity of fw_update in the control register 161 (e.g., fw_update=1). Accordingly, the second memory controller 15 and the first memory controller 12 work together to copy the content of the OTA upgrade version from flash B into the first NVM 11. After the copying is completed, the second memory controller 15 identifies the validity of SWAP and accordingly updates flash B as a default backup bank for the first NVM 11.

In S303, the CPU is released, and a bootloader is launched to run the content of the OTA upgrade version in the RRAM. Here, the bootloader is a program provided by the MCU manufacturer for handling system startup. It is not user-modifiable and can be stored in an address range of the first NVM 11 or second NVM 20, which is user-readable but not user-writable (e.g., flash C).

In S304, the bootloader programs (or sets) fw_update to an invalid value (e.g., fw_update=0) and, after the CPU successfully runs the content of the OTA upgrade version in the RRAM, clears ota_success by writing a '1' to it.

Therefore, the memory controller of the present embodiment can use one of the first and second backup banks of the second NVM as a default backup bank for supporting execution of an ongoing program of the system, the other as an OTA upgrade backup bank for supporting OTA upgrade control. In this way, during OTA upgrading, it is unnecessary to interrupt the execution of the ongoing program of the system.

Additionally, it will be understood that, when there is a need to read corresponding backup content from the default backup bank of the second NVM 20 and return it to the system bus (e.g., as a consequence of the system bus detecting an error in the content of the first NVM 11, or a corrupted address therein), the second memory controller 15 will automatically read corresponding backup content from the default backup bank of the second NVM 20 according to the configuration information and return it to the system bus through an appropriate return path. For example, if the second bus interface 14 is included, the read backup content may be returned via the following return path: second NVM 20 (i.e., the default backup bank) -> second memory controller 15 -> second bus interface 14 -> system bus. If the second bus interface 14 is not included, the read backup content may be returned via the following return path: second NVM 20 (i.e., the default backup bank) -> second memory controller 15 -> first memory controller 12 -> first bus interface 13 -> system bus. Obviously, the backup content can be returned onto the system bus, whether the second bus interface 14 is included or not, but a shorter return path allowing faster reading can be established with the second bus interface 14. Therefore, the second bus interface 14 can be either included or omitted, as required.

In the present embodiment, the second memory controller 15 is also configured to, when out of an OTA upgrading phase, in response to the system bus identifying a corrupted address in the first NVM 11 from the configuration information (or option byte or control register 161), automatically read corresponding backup content from the default backup bank of the second NVM 20 and return it onto the system bus via the first memory controller 12, or via the second bus interface 14.

In one example, with combined reference to Fig. 3, the first memory controller 12 includes a first soft error correction module (ECC_r1) 121 having at least one of the following functions: (1) as the system bus writes content into the first NVM 11, generating a corresponding error checking and correction (ECC) code 112 and storing it in the first NVM 11 along with the corresponding content; (2) as the system bus reads the corresponding content from the first NVM 11, reading the ECC code 112 and performing an ECC process on the corresponding read content in real time using the ECC code 112, wherein if the configuration information (or option byte or control register 161) pre-configures that the first NVM 11 is not to be repaired, when an error founded in the ECC process meets its error correction ability, it corrects the error and provides the corrected content on the system bus, or regardless of whether the configuration information pre-configures that the first NVM 11 is to be repaired or not, when an error founded in the ECC process meets its error correction ability, it corrects the error and provides the corrected content on the system bus, and in the latter case, when the memory controller (NVMC) becomes idle at a later time, the second memory controller reads corresponding backup content from the default backup bank and writes the backup content into the first NVM 11 for content repair; (3) as the second memory controller 15 backs up content of the first NVM 11 into the default backup bank of the second NVM 20, generating a corresponding ECC code (e.g., 202 of Fig. 6) and instructing the second memory controller 15 to store the ECC code (e.g., 202 of Fig. 6) in the second NVM 20 along with the content of the first NVM 11; and (4) before the first memory controller 12 returns backup content read by the second memory controller 15 onto the system bus or writes it into the first NVM 11 for content repair, reading the ECC code (e.g., 202 of Fig. 6) and performing an ECC process on the backup content read by the second memory controller 15 from the second NVM 20 according to the ECC code (e.g., 202 of Fig. 6).

For example, the ECC ability of the first soft error correction module 121 may be single-bit error-correction, double-bit error detection (SEC-DED), double-bit error-correction, three-bit error detection (DEC-TED) or the like. SEC-DED is the ability of the first soft error correction module 121 to correct 1 bit of content at a certain address in the first NVM 11 and checks 2 bits of content at a certain address in the first NVM 11. DEC-TED is the ability of the first soft error correction module 121 to correct 2 bits of content at a certain address in the first NVM 11 and checks 3 bits of content at a certain address in the first NVM 11.

In this embodiment, using the first soft error correction module 121, the memory controller is able to check the correctness of data, i.e., perform error checking on content, from the first NVM 11 in real time and correct errors of a small number of bits (e.g., one-bit errors) in content from the first NVM 11. Such real-time ECC ensures correctness of content from the first NVM 11 and is time-saving. Moreover, as the content processed by the ECC function is correct, the system is allowed to continue executing an ongoing program without any interrupt.

Optionally, referring to Fig. 6, the first memory controller 12 may include the first soft error correction module (ECC_r1) 121, and the second memory controller 15 may include a second soft error correction module (ECC_r2) 151. In this case, the first soft error correction module (ECC_r1) 121 may have the following functions: (1) as the system bus writes content into the first NVM 11, generating a corresponding ECC code 112 and storing it in the first NVM 11 along with the corresponding content; and (2) as the system bus reads the corresponding content from the first NVM 11, reading the ECC code 112 and performing an ECC process on the read corresponding content in real time using the ECC code 112, wherein if the configuration information (or option byte or control register 161) pre-configures that the first NVM 11 is not to be repaired, when an error founded in the ECC process meets its error correction ability, it corrects the error and provides the corrected content on the system bus, or regardless of whether the configuration information pre-configures that the first NVM 11 is to be repaired or not, when an error founded in the ECC process meets its error correction ability, it corrects the error and provides the corrected content on the system bus, and in the latter case, when the memory controller becomes idle at a later time, the second memory controller 15 reads corresponding backup content from the default backup bank and writes the backup content into the first NVM 11 for content repair. The second soft error correction module 151 may have the following functions: (1) as the second memory controller 15 backs up content of the first NVM 11 into the second NVM 20, generating a corresponding ECC code 202 and instructing the second memory controller 15 to store the ECC code 202 in the second NVM 20 along with the content of the first NVM 11; and (2) before the first memory controller 12 returns backup content read by the second memory controller 15 onto the system bus or writes it into the first NVM 11 for content repair, reading the ECC code 202 and performing an ECC process on the backup content read by the second memory controller 15 from the second NVM 20 according to the ECC code 202.

With this arrangement, the first soft error correction module 121 can provide ECC protection to content written to the first NVM 11 and the second soft error correction module 151 can provide ECC protection to backup content written to the second NVM 20, increasing storage reliability of the first NVM 11 and the second NVM 20.

Optionally, the second memory controller 15 may be further configured to, when the error detected by the first soft error correction module 121 still exists or exceeding the error correction ability of the first soft error correction module 121, and if the configuration information (or option byte or control register 161) pre-configures that the first NVM 11 is to be repaired, read backup content from the second NVM 20, write it to the first NVM 11 for content repair and instruct the system bus to read back corresponding content from the first NVM 11 to verify whether the repair is successful.

Referring to Figs. 3 and 6, in the memory controller of the present embodiment, the register bank 16 may further include status register 162. When the configuration information (or option byte or control register 161) pre-configures that the first NVM 11 is not to be repaired, the status register 162 may record first status information about a result of ECC performed by the first soft error correction module 121 on the first NVM 11, which may contain statuses and addresses of errors. When the configuration information (or option byte or control register 161) pre-configures that the first NVM 11 is to be repaired, the status register 162 may record second status information about a result of repair of the first NVM 11, which may contain at least one of statuses, addresses and the number of repair-failed errors and the number of repair failures.

The first or second memory controller 12 or 15 may be further configured to record addresses of repair-failed errors in the first NVM 11 (either addresses of the individual errors, or start and end addresses of a block containing the errors) in the status register 162, which are then stored in the configuration information of the option byte Opt as corrupted addresses according to a software strategy, or not.

The second memory controller 15 may be further configured to, when the system bus reads a corrupted address from the configuration information and/or a recorded error address from the status register 162, automatically skip the first NVM 11, read corresponding backup content from the second NVM 20 and return it onto the system bus. For example, if the software strategy determines that an error address recorded in the status register 162 is a corrupted address, and is stored in (or updated to) the configuration information of the option byte Opt, when the system bus reads the error address recorded in the status register 162 (i.e., the corrupted address that has been updated to the configuration information) next time, the first memory controller 12 may skip the corrupted address and instruct the second memory controller 15 to automatically read backup content from the second NVM 20 and return it onto the system bus. In this way, based on the previous records in the status register 162, the memory controller 10 of the present embodiment can read correct content (i.e., backup content) corresponding to errors or problematic addresses (collectively referred to as "corrupted addresses" hereinafter) in the first NVM 11 at a higher speed.

Optionally, the status register 162 may be further configured to generate an interrupt according to records therein, which allows the CPU or another master on the system bus to take a corresponding subsequent action.

It will be understood that the status register 162 may be only readable and clearable by the CPU, and may be implemented either as a single register, or as a register bank consisting of multiple registers (e.g., including address registers, an error count register, a failure count register, a result register indicative of successful or unsuccessful repair), without limiting the present invention in any sense.

Optionally, the configuration information of the option byte Opt may also configure a threshold number of repeated repair attempts, and the second memory controller 15 may be further configured to make repeated attempts to repair errors in the first NVM 11 with corresponding backup content from the second NVM 20 until the threshold is reached. If the errors are not successfully repaired even when the number of repeated repair attempts that have been made reaches the threshold, it is considered that repair of the first NVM 11 fails.

Optionally, the first memory controller 12 may further include a counter module 122 for counting at least one of: the numbers of errors detected by the first soft error correction module 121 in the first NVM 11; repeated attempts that have been made to repair the errors in the first NVM 11; and repair-failed errors in the first NVM 11.

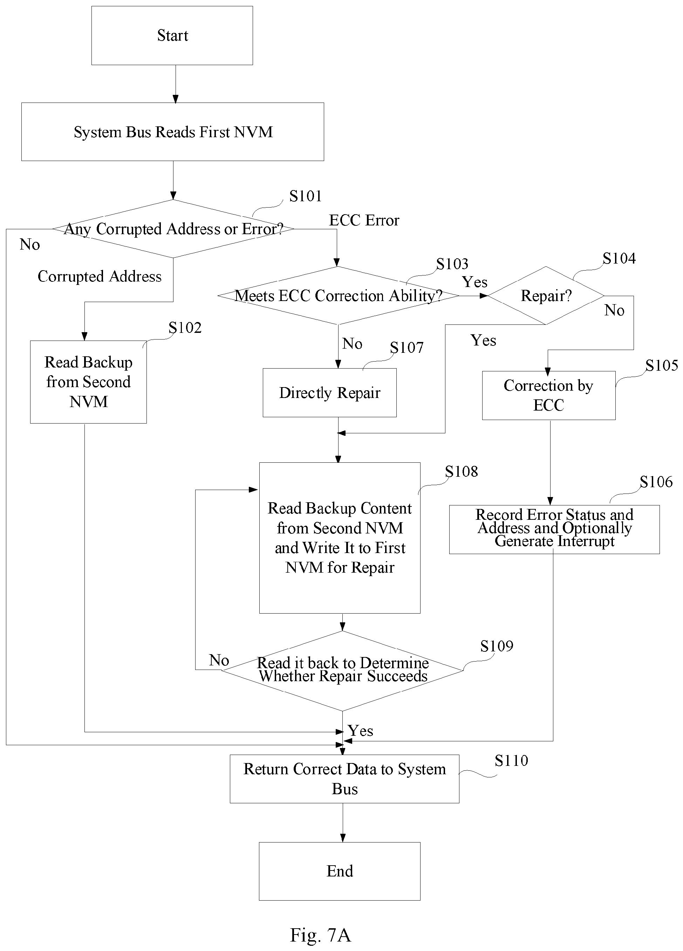

In one example, referring to Fig. 7A, in conjunction with Figs. 3 and 6, when out of an OTA upgrading phase (i.e., in a default condition), as the CPU (or another master on the system bus, such as DMA or the like) reads the first NVM 11 via the system bus, the memory controller 10 of the present embodiment may perform an ECC and real-time repair process on the first NVM 11, which may include the steps described below.

In S101, the first memory controller 12 determines whether a corrupted address is read from the configuration information loaded in the control register 161 (or from the option byte Opt or control register 161). If not, the first soft error correction module 121 (which is a hardware ECC circuit) performs real-time error checking on content read from the first NVM 11 to detect, in real time, whether there is an error in the content from the first NVM 11.

If an address range that the first memory controller 12 reads does not encompass a corrupted address in the configuration information and the read content is free of errors (this is called a "first read situation"), the process jumps to step S110 to return the correct content onto the system bus (i.e., the first memory controller 12 returns the content read from the first NVM 11 directly to the CPU via the first bus interface 13). The CPU reads the correct content, and the program of system is executed without being affected.

If the first memory controller 12 reads a corrupted address from the configuration information (or from the non-volatile option byte Opt or control register 161) ("second read situation"), the process proceeds to step S102, in which the second memory controller 15 automatically reads, based on the corrupted address, corresponding backup content from the default backup bank of the second NVM 20. Moreover, step S110 is then carried out, in which the second memory controller 15 returns the correct content to the system bus. That is, it returns the content to the CPU, via the first memory controller 12 and the first bus interface 13, or via the second bus interface 14. Although the operation in the second read situation takes more time than that in the first read situation, the CPU can still read correct data, so the system program can continue to be executed without being interrupted.

If the first soft error correction module 121 confirms an error in the content read by the first memory controller 12 ("third read situation"), it then carries out step S103 to determine whether the error in the content read by the first memory controller 12 meets its error correction ability. If yes, i.e., if a small number of bit errors are identified in the content read by the first memory controller 12 and meet the error correction ability (e.g., 1 bit error) of the first soft error correction module 121, the process proceeds to step S104, in which the configuration information (or control register 161 or option byte Opt) pre-configures whether repair of the first NVM 11 is to be conducted or not (the "repair" mentioned here and hereafter refers to reading backup content from the default backup bank of the second NVM 20).

If the first NVM 11 is not to be repaired, then step S105 is carried out, in which the first soft error correction module 121 performs ECC to correct the errors in the content. Moreover, step S106 is carried out to record first status information containing, among others, statuses (brk_status, e.g., 1-bit or 2-bit), addresses (brk_addr) and the number (brk_times, e.g., the number of 1-bit error and the number of 2-bit errors) of errors in the status register 162. After that, step S110 is carried out to return the correct content to the system bus, i.e., return the content that has been ECC-corrected by the first soft error correction module 121 to the CPU via the first memory controller 12 and the first bus interface 13, or via the first bus interface 13. Since the ECC-corrected content is correct, the program of the system can still be executed without being interrupted. It will be understood that the status register 162 may be implemented as a register bank consisting of multiple registers for recording the respective content items of the first status information. Optionally, the status register 162 may further generate an interrupt based on the recorded error statuses and addresses and other information and hand it over to the CPU for subsequent handling.

If the first NVM 11 is to be repaired, then step S108 is carried out, in which the second memory controller 15 reads corresponding backup content from the default backup bank of the second NVM 20, and the first memory controller 12 writes it to the first NVM 11 for content repair (i.e., via the "default backup bank of second NVM 20 -> second memory controller 15 -> first memory controller 12 -> first NVM 11" path). After that, step S109 is carried out, in which the first memory controller 12 reads back the content and determines whether the repair succeeds (i.e., whether the "first NVM 11 -> first memory controller 12 -> first bus interface 13" path works properly). If the repair is successful, step S110 is carried out to return the correct content to the CPU to enable it to continue executing the program. If the repair fails, the step S108 may be repeatedly carried out to make other repair attempts. The number of such repeated repair attempts does not exceed an associated threshold (i.e., the repair succeeds before the number of repeated repair attempts that have been made reaches the threshold, or the repair does not succeed even when the number of repeated repair attempts that have been made reaches the threshold). Alternatively, step S106 may be carried out to record second status information in the status register 162, which contains the statuses, addresses and number of repair-failed errors, among others. Optionally, the status register 162 may further generate an interrupt based on the second status information that contains error statuses, addresses, etc. and hand it over to the CPU for subsequent handling.

In step S103, if it is determined that the errors in the content read by the first memory controller 12 exceed the error correction ability of the first soft error correction module 121 (e.g., 2 bit errors), then step S107 is carried out to directly repair the first NVM 11.

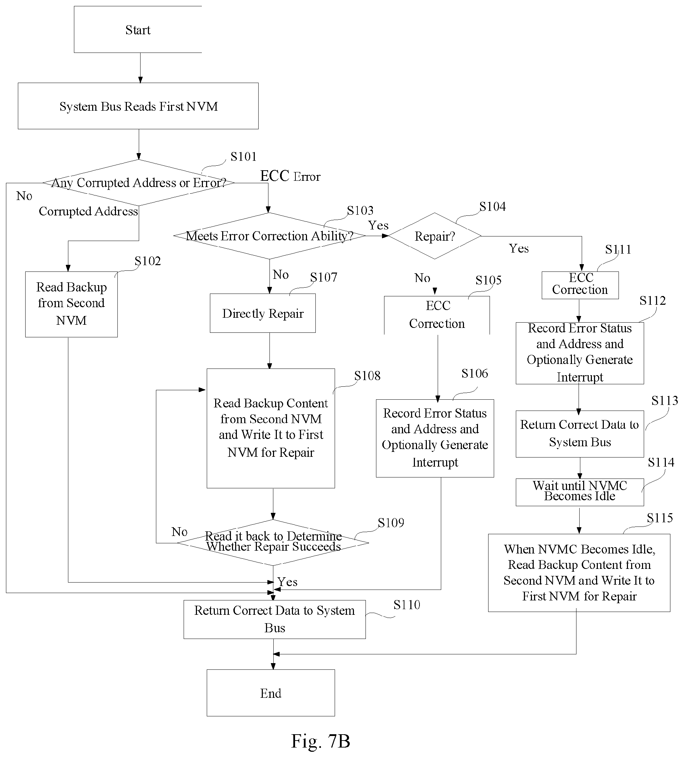

In another example, as shown in Fig. 7B, an ECC and real-time repair process performed by the memory controller 10 of the present embodiment on the first NVM 11 differs from the process in the above example of Fig. 7A in that, when it is determined in step S103 that errors in content read by the first memory controller 12 meet the error correction ability of the first soft error correction module 121, and if the configuration information (or control register 161 or option byte Opt) configures in step S104 that the first NVM 11 is to be repaired, the following steps are sequentially performed.

In S111, the first soft error correction module 121 corrects the errors in the content. The correction in S111 may be accomplished in the same way as in step S105 as described above, and further description thereof is deemed unnecessary.

In S112, first status information containing statuses, addresses and the number of errors and the like is recorded in the status register 162. Step S112 may be the same as step S106 as described above, and further description thereof is deemed unnecessary.

In S113, the content that has been ECC-corrected by the first soft error correction module 121 is returned to the system bus. Step S113 may be the same as step S110 as described above, and further description thereof is deemed unnecessary.

In S114, nothing is done until the memory controller (NVMC) becomes idle.

In S115, when the memory controller (NVMC) becomes idle, the second memory controller 15 reads corresponding backup content from the default backup bank of the second NVM 20, and the first memory controller 12 writes it to the first NVM 11 for content repair. Step S115 may be the same as step S108 as described above, and further description thereof is deemed unnecessary.

Therefore, in this example, if the configuration information pre-configures that the first NVM 11 is to be repaired, when a small number of errors are detected, the errors are first ECC-corrected, and the corrected content is then returned to the system bus, avoiding the execution of an ongoing program of the system from being interrupted. Moreover, the first NVM 11 is repaired when the memory controller (NVMC) becomes idle, enabling rational utilization of the system's resources.

In other words, in the example of Fig. 7B, as the system bus reads the first NVM 11, if the first soft error correction module 121 detects by ECC a number of errors meeting its error correction ability, regardless of whether the configuration information (or control register 161 or option byte Opt) pre-configures that the first NVM 11 is to be repaired, the first soft error correction module 121 will correct the errors that it detects and provide the ECC-corrected content to the system bus in time, avoiding the execution of an ongoing program of the system from being interrupted.

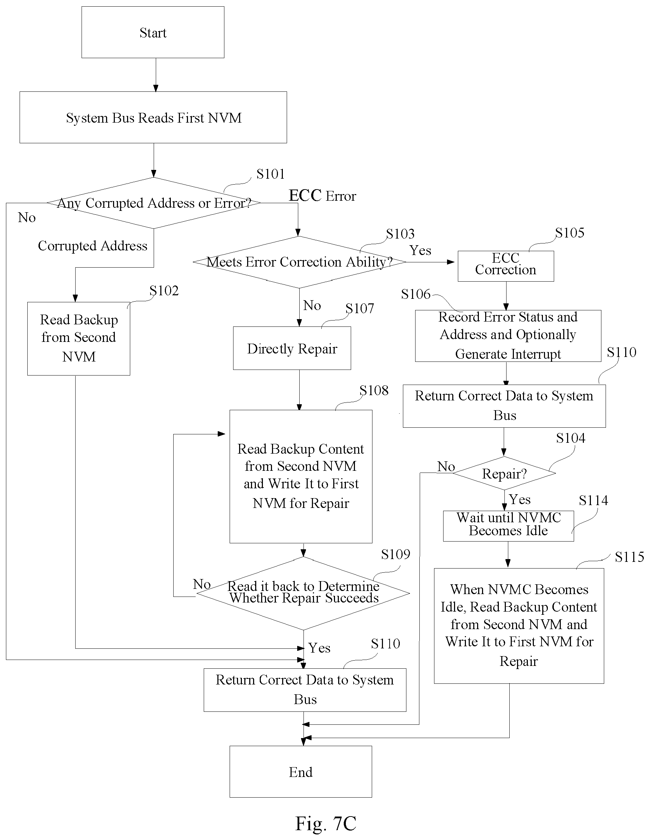

Since the process of Fig. 7B includes identical steps, simpler, more efficient processes can be obtained in other examples by altering the order of steps in this process. For example, in the example of Fig. 7C, an ECC and real-time repair process performed by the memory controller 10 on the first NVM 11 differs from the process in the above example of Fig. 7B in that, following the completion of step S103, steps S105 (correcting errors detected in content by the first soft error correction module 121), S106 (recording first status information containing statuses, addresses and the number of errors and the like in the status register 162) and S110 (returning the content that has been ECC-corrected by the first soft error correction module 121 to the system bus) are carried out before Step S104 (determining whether the configuration information pre-configures that the first NVM 11 is to be repaired or not). If it is determined that the configuration information pre-configures that the first NVM 11 is to be repaired, steps S114 (waiting until the memory controller (NVMC) becomes idle) and S115 (after the memory controller (NVMC) becomes idle, reading corresponding backup content from the default backup bank of the second NVM 20 by the second memory controller 15 and writing the read content to the first NVM 11 by the first memory controller 12 for content repair) are carried out. Thus, steps S111 to S113 are omitted.

In the processes in the above examples, the first NVM 11 may be repaired address by address, or in a block-wise manner (e.g., each block consists of one row of memory cells). When the first NVM 11 is configured not to be repaired, addresses of detected errors may be automatically recorded in the status register 162 (i.e., reported), and one or more repair attempts may be made subsequently to correct the errors if required.

Further, any repair-failed address may be automatically recorded by the first or second memory controller 12 or 15 in the status register 162 (i.e., reported), and a determination may be then made according to a software strategy of the CPU of whether or not to store it in the option byte Opt as a corrupted address. If it is determined according to the software strategy of the CPU that the repair-failed address is stored in the option byte Opt as a corrupted address, then when the CPU tries to read the address at a later time, the memory controller 10 will automatically read corresponding backup content from the default backup bank of the second NVM 20 according to the configuration information in the option byte Opt and return it to the system bus.

Furthermore, if any address fails to be repaired even after repeated repair attempts have been made, the second memory controller 15 may assert it as a corrupted address (or simply a "bad address"). Alternatively, it may assert a row or block of memory cells containing the address as a bad row or block. For example, physically, one or more bits in a row of memory cells may fail or be damaged due to a short circuit or other reasons, and repair fails even when the number of repeated repair attempts that have been made by software reaches a threshold predefined in the configuration information. Accordingly, these bits can be considered as having been physically damaged, or one or more rows or blocks containing the bits can be considered as bad rows or blocks that have been physically damaged. The first or second memory controller 12 or 15 may record any corrupted address or an address of any bad row or block in the status register 162 (i.e., error address reporting), indicating that the previous "second NVM 20 -> second memory controller 15 -> first memory controller 12 -> first NVM 11 -> (read back) first bus interface 13" path has failed and it may be stored in the option byte Opt (i.e., updated to the configuration information) as a corrupted address, or not, according to a software strategy of the CPU. If it is finally determined that the address is stored in the option byte Opt as a corrupted address according to the software strategy of the CPU, then when the CPU reads the recorded address at a later time, it will skip the first NVM 11 and read corresponding backup content from the default backup bank of the second NVM 20 via the "default backup bank of the second NVM 20 -> second memory controller 15 -> first memory controller 12 -> first bus interface 13" path or "default backup bank of the second NVM 20 -> second memory controller 15 -> second bus interface 14" path.

In this way, the memory controller of the present embodiment can read in real time backup content corresponding to a problematic address, without interrupting an ongoing program being executed. Moreover, when there is any physically damaged address or bad row or bad block in the first NVM 11, the memory controller can automatically skip it and allows the system to continue operation, increasing the security of the MCU chip.

### Embodiment 2

Referring to Fig. 8, a memory controller 10 according to a second embodiment is coupled to second NVM (e.g., flash memory) 20 and includes first NVM 11, a first memory controller 12, a first bus interface 13, a second bus interface 14, a second memory controller 15 and a register bank 16 (including a control register 161 and a status register 162).

With combined reference to Figs. 8 and 9, compared with the first embodiment, the present embodiment additionally includes a self-check module 123 in the first memory controller 12 and an OTA upgrade check flag ota_check in the control register 162. The OTA upgrade check flag ota_check is configured to indicate whether to perform a self-check in an OTA upgrading phase on the content of an OTA upgrade version copied into the first NVM 11. If yes, ota_checkis valid. Otherwise, ota_check is invalid. The self-check module 123 is configured to perform, when ota_check is valid, a self-check on the content of the OTA upgrade version copied into the first NVM 11.

Referring to Fig. 9, the memory controller 10 of the present embodiment further includes an OTA upgrade flag fw_update, a backup bank mapping control flag SWAP, an OTA upgrade success flag ota_success, the OTA upgrade check flag ota_check and an OTA upgrade failure flag ota_fail. The OTA upgrade flag fw _update, the backup bank mapping control flag SWAP and the OTA upgrade success flag ota_success function in the same way as those in the first embodiment and are not repeated here. The OTA upgrade check flag ota_check is configured to indicate whether to perform a self-check in an OTA upgrading phase on the content of an OTA upgrade version copied into the first NVM 11. If yes, ota_check is valid (e.g., ota_check=1). Otherwise, ota_checkis invalid (e.g., ota_check=0). The OTA upgrade failure flag ota_fail is opposite or complementary to the OTA upgrade success flag ota_success, and the two work together to indicate success or failure of the OTA upgrade. When the OTA upgrade fails, ota_fail is cleared by writing a '1'. This ensures a reliable indication of the OTA upgrade result.

In the present embodiment, the OTA upgrade flag fw _update, the backup bank mapping control flag SWAP and the OTA upgrade check flag ota_check are provided in an option byte or the control register 161. This enables them not to lose the data stored thereon in the event of a power loss. The OTA upgrade failure flag ota_fail and the OTA upgrade success flag ota_success are provided in an ordinary control register and therefore will lose the data stored thereon when power is lost.

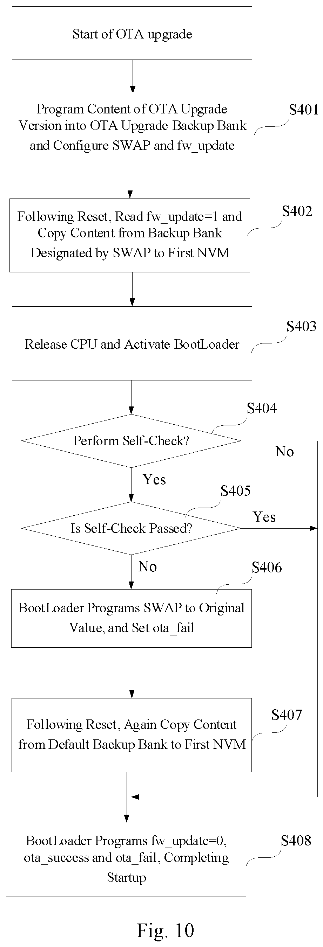

Referring to Figs. 8 to 10, a process performed by the memory controller 10 of the present embodiment to carry out an OTA upgrade includes the steps described below.

In S401, flash A is a default backup bank, and flash B is an OTA upgrade backup bank. The second memory controller 15 programs the content of an OTA upgrade version (e.g., an updated firmware program) into flash B (i.e., the OTA upgrade backup bank). The second or first memory controller 15 or 12 sets SWAP in the control register 161 to a valid value (e.g., SWAP=1, indicating that flash B is to be subsequently updated as a default backup bank) and fw_update in the control register 161 to a valid value (e.g., fw_update=1). In this process, as a software program runs on the first NVM 11, even when any error is found in the content of the first NVM 11, it can be ECC corrected or repaired with backup content from flash A, it is unnecessary to interrupt the program.

In S402, a POR or system reset occurs, and the first memory controller 12 identifies the validity of fw_update in the control register 161 (e.g., fw_update=1). Accordingly, the second memory controller 15 and the first memory controller 12 work together to copy the content of the OTA upgrade version from flash B into the first NVM 11. After the copying is completed, the second memory controller 15 identifies the validity of SWAP and accordingly updates flash B as a default backup bank for the first NVM 11.

In S403, the CPU is released, and a bootloader is launched. Here, the bootloader is a program provided by the MCU manufacturer for handling system startup. It is not user-modifiable and can be stored in an address range of the first NVM 11 or second NVM 20, which is user-readable but not user-writable (e.g., flash C).

In S404, the first memory controller 12 reads ota_check in the control register 161. If ota_check is invalid (e.g., ota_check=0), it is not needed to perform a self-check on the content of the OTA upgrade version in the first NVM 11, and the content of the OTA upgrade version in the first NVM 11 can be directly read and run. After that, step S408 is carried out, in which the bootloader programs (or sets) fw_update to an invalid value (e.g., fw_update=0) and, depending on whether the content of the OTA upgrade version in the first NVM 11 is successfully run (i.e., whether OTA upgrade succeeds), the bootloader programs (or sets) ota_success and ota_fail. If the OTA upgrade is successful, then ota_success is cleared by writing a '1' to it. If the OTA upgrade fails, then ota_check is cleared by writing a '1' to it.

If ota_check is valid, then step S405 is carried out, in step S405, the self-check module 123 performs a self-check on the content of the OTA upgrade version in the first NVM 11 and determines whether the content of the OTA upgrade version in the first NVM 11 passes the self-check (i.e., whether the content of the OTA upgrade version in the first NVM 11 is correct or not). If it passes the self-check, step S408 is carried out, in which the bootloader programs (or sets) fw_update to an invalid value and programs ota_success to a valid value (i.e. clear it by writing a '1' to it). If it does not pass the self-check, step S406 is carried out, in which the bootloader programs (or sets) SWAP to an original value and programs ota_fail to a valid value (i.e. clear it by writing a '1' to it). Moreover, step S407 is carried out, in which a reset is generated, and the content of flash A (i.e., the default backup bank) is copied back to the first NVM. The content of the old version is then run, and step S408 is carried out, in which the bootloader programs (or sets) fw_update to an invalid value (e.g., fw_update=0).

Optionally, the second NVM 20 may have a plurality of default backup banks (e.g., flash A) separately storing backups of different old versions. When the OTA upgrade fails, the second memory controller 15 may be further configured to copy the backup content of a corresponding old version stored in a designated one of the default backup banks to the first NVM 11 according to rollback command (i.e., the bootloader programs SWAP back to an original value corresponding to the designated default backup bank). Thus, in this embodiment, when an OTA upgrade fails, the system is allowed to roll back to a designated old version, avoiding a crash or other issues that may otherwise arise from the OTA upgrade failure.

Moreover, unlike embedded flash memory, data stored in the first NVM is susceptible to interference from the surrounding environment or the like and very likely to experience changes. Therefore, in the memory controller of the present embodiment, the self-check module 123 is included to perform a self-check on the content of the first NVM 11 at any suitable time out of an OTA upgrading phase, such as following a POR or system reset, or during running of the system. This ensures reliability of the content of the first NVM, increases correctness of content read by the CPU from the first NVM 11, reduces the number of times of ECC process or error repair with backup content from the second NVM 20 performed on content from the first NVM 11, and accelerates and improves consistency of the system's operation.

As an example, when out of an OTA upgrading phase, the self-check module 123 is configured to perform a self-check on the content of the first NVM 11 following a power-on reset (POR) or system reset, or during running of the system, by reading the content from the first NVM 11 and comparing it with the corresponding backup content in the default backup bank of the second NVM 20. No difference therebetween means correctness of the content of the first NVM 11, and any difference therebetween means the existence of an error or errors in the content of the first NVM 11. With this arrangement, when out of an OTA upgrading phase, the self-check module 123 can automatically check the content of the first NVM 11 at any suitable time (e.g., following a reset, or during running of the MCU), and any detected error can be handled by ECC or real-time repair. This can facilitate use by users.

In the present embodiment, setting of self-check option byte is added to the option byte Opt for self-check control. The configuration information stored in the self-check option byte includes a self-check address range and at least one register value. In other words, the configuration information of the option byte loaded in the control register 161 includes not only configuration information necessary for error checking and real-time repair of the first NVM 11 but also configuration information necessary for performing a self-check at any time suitable for the system (e.g., in an OTA upgrading phase, following a POR or system reset, during running of the system, etc.)

The self-check address range is an address range of the first NVM 11, where content is to be checked by the self-check module 123. For example, the address range may be the entire address space of the first NVM 11, or part thereof. The register value or values determine whether the self-check module 123 is to perform a self-check on the content of the first NVM 11 and, if yes, the time when the self-check is to be carried out by the self-check module 123 (e.g., in an OTA upgrading phase, following a POR or system reset, during running of the system, or any other suitable time). The setting of the self-check may be configured by read and write operations of software after the CPU starts running. After a system reset occurs, the first memory controller 12 may read the self-check settings in the option byte (Opt) and load them in the control register 161, thereby validating these settings.

Accordingly, in addition to status information (including first status information about ECC and second status information about real-time repair) generated during reading of the first NVM 11 as the system is running, the status register 162 is also configured to record third status information generated during the self-check, which include at least one of statuses and addresses of errors detected during the self-check and the number of repair-failed errors.

For example, the status register 162 may include a first register (not shown) and a second register (not shown). As the system bus reads the first NVM 11, the first register is configured to record, when the configuration information configures that the first NVM 11 is not to be repaired, first status information about a result of ECC performed by the first soft error correction module 121 on the first NVM 11, which contains statuses and addresses of errors. Moreover, when the configuration information configures that the first NVM 11 is to be repaired, first register is also configured to record second status information about a result of repair of the first NVM 11, which contains at least one of statuses, addresses and the number of repair-failed errors and the number of repair failures. The first register is further configured to record other related status information.

As the self-check module 123 performs a self-check on the first NVM 11, the second register is configured to record third status information about a result of the self-check on the first NVM 11 (including ECC and repair), which contains at least one of statuses and addresses of errors detected in the self-check, the number of repair-failed errors, etc.

Further, referring to Fig. 8, when a register value about the self-check settings in the optional byte is configured to indicate that a self-check is to be carried out (i.e., a register value in the configuration information is configured to a specified value indicating that a self-check is to be performed at a specified time), the self-check module 123 is configured to successively read, at a self-check time specified by register value in the self-check option byte, content at each address in the self-check address range of the first NVM 11 indicated in the self-check option byte and compare it with corresponding backup content in the second NVM 20. For content at each address in the first NVM 11, if no difference is found in the comparison made with the corresponding backup content, then it is considered to be correct, and content at the next address in the self-check address range is then checked. This is repeated until the end of the self-check address range is reached. If content at any address in the first NVM 11 is found to be different from the corresponding backup content, an error in the content is identified. When this takes place, if the option byte or control register 162 pre-configures that the first NVM 11 is to be repaired, the second memory controller 15 is further configured to read backup content corresponding to the error found in the first NVM 11 by the self-check module 123 from the second NVM 20 and write it to the first NVM 11 for content repair. After that, the self-check module 123 reads back the content and re-compares it.

Optionally, when the self-check module 123 detects an error in the first NVM 11, which meets the error correction ability of the first soft error correction module 121, and if the configuration information (or option byte or control register 161) pre-configures that the first NVM 11 is not to be repaired, the first soft error correction module 121 may be further configured to correct by ECC the error in the first NVM 11 detected by the self-check module 123.

Optionally, the first memory controller 12 may further include a counter module 122 for counting at least one of the number of errors in the first NVM 11 detected by the first soft error correction module 121, the number of errors in the first NVM 11 detected by the self-check module 123, the number of repeated repair attempts made by the second memory controller 15 to the first NVM 11 and the number of errors in the first NVM 11 that the second memory controller 15 fails to repair. Based on count value(s) stored in the counter module, the memory controller of the present invention is able to determine whether to generate an interrupt, whether to perform error repair, etc.

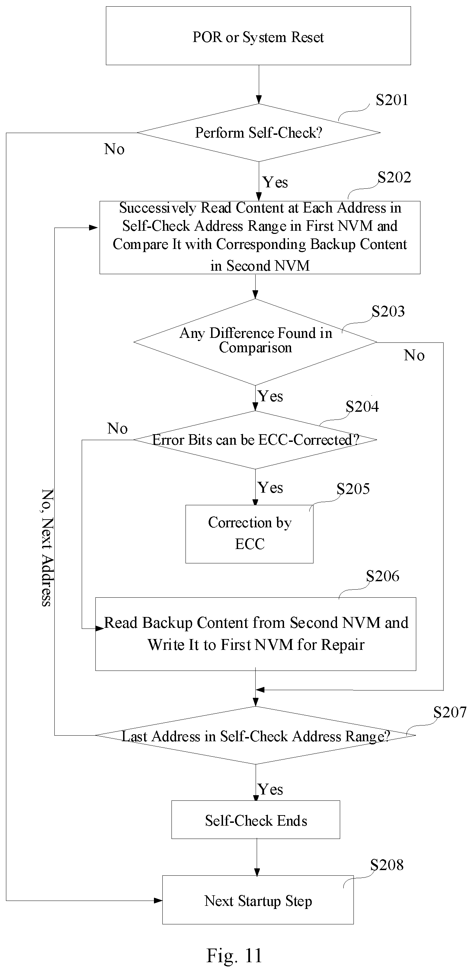

Referring to Fig. 11, a self-check performed by the memory controller 10 of the present embodiment out of an OTA upgrading phase following a reset (whether a system reset or a POR) is described in detail below, as an example. The self-check may include the steps described below.

In S201, following the reset, the memory controller 10 (e.g., the first memory controller 12 therein) reads the option byte Opt that is stored in the first NVM 11 or the second NVM 20 and re-loads it into the control register 161, validating self-check and other settings therein. The memory controller 10 (e.g., the self-check module 123 in the first memory controller 12) determines, based on a register value in the configuration information that is loaded in the control register 161, whether to perform a self-check on the content of the first NVM 11.

If the register value indicates that no self-check is to be conducted, all the other steps in the self-check are skipped, and the system carries out step S208 initiating the next startup step.

If the register value indicates that a self-check is to be conducted, then step S202 is carried out, the self-check module 123 successively reads content at each address in a self-check address range of the first NVM 11 indicated in the configuration information loaded in the control register 161 and compares it with corresponding backup content read by the second memory controller 15 from the second NVM 20.

For content at each address in the first NVM 11, if no difference is found in step S202, then it is considered to be correct, and, the control proceeds to step S207 in which the self-check module 123 determines whether the address is the last addresses in the self-check address range. If not, the control proceeds to step S202 and the next address is checked. If yes, the self-check is completed, and the control proceeds to step S208.

If a difference is identified in step S202, the control proceeds to step S204, the self-check module 123 determines whether the error in the content of the first NVM 11 meets the error correction ability of the first soft error correction module 121, i.e., whether the error can be ECC-corrected.

If the error meets the error correction ability of the first soft error correction module 121 (e.g., the first soft error correction module 121 comprises SEC-DED ability, and the error detected in the first NVM 11 through self-check is 1 bit), then according to the configuration information loaded in the control register 161, the following two situations are considered: 1) if the configuration information configures that repair is not to be conducted, i.e., the error can be ECC-corrected, then step S205 is carried out, the self-check module 123 enables the first soft error correction module 121 to correct the error in the first NVM 11 by ECC, and the control then proceeds to step S207; 2) if the configuration information configures that repair is to be conducted, then S206 is carried out, the self-check module 123 enables the second memory controller 15 to read corresponding backup content from the second NVM 20, which is then written by the first memory controller 12 to the address in the first NVM 11 to refresh the content and repair the error.

If the error exceeds the error correction ability of the first soft error correction module 121 (i.e., the error detected by the self-checked at the current address cannot be ECC-corrected; for example, the first soft error correction module 121 comprises SEC-DED ability, while two- or more-bit errors are detected in the first NVM 11 through the self-check), then according to the configuration information loaded in the control register 161, the following two situations are considered: 1)if the configuration information configures that repair is not to be conducted, as the detected error cannot be ECC-corrected, even if the self-check module 123 enables the first soft error correction module 121 to work, however the first soft error correction module 121 cannot correct the error in the first NVM 11. Accordingly, the current address may be skipped, and the control may proceed to step S207; 2) if the configuration information configures that repair is to be conducted, then S206 is carried out, in which the self-check module 123 enables the second memory controller 15 to read corresponding backup content from the second NVM 20, which is then written by the first memory controller 12 to the current address in the first NVM 11 to refresh the content and repair the error (e.g., 2-bit).

Additionally, in step S206, the content written to the current address in the first NVM 11 may be read back to verify whether the repair is successful. If the repair is successful, skipping to step S208 to perform the self-check on the next address. If the repair is unsuccessful, step S206 is repeated to make additional repair attempts. The number of such repeated repair attempts does not exceed a threshold configured in the configuration information, that is, the following two results of self-check of the current address can be obtained: 1) its repair succeeds before the number of repeated repair attempts that have been made reaches the threshold; or 2) when the number of repeated repair attempts that have been made reaches the threshold, the repair fails. Any of the two result obtains, the self-check of the current address ends, and the control then proceeds to step S207 to check the next address. If the repair of the current address in the first NVM 11 finally fails, information about the repair-failed error, such as its status, address and number, is recorded in the status register 162. Additionally, for example, a block containing the repair-failed address may be labeled as a bad block, allowing the system to bypass the address, or automatically skip the first NVM 11 and read the corresponding backup content from the second NVM 20 when this the address is used.

The self-check for the content of the first NVM 11 ends when each address in the self-check address range has been checked (or scanned), and the control then proceeds to step S208 to initiate the next startup step.

If an anomaly (e.g., physical damage, etc.) of the second NVM 20 is reported during the self-check, an interrupt may be generated to notify the CPU to allow CPU software to devise a subsequent countermeasure.

Optionally, if the number of repair-failed errors detected in the self-check exceeds a preset threshold, an interrupt may be generated to notify the CPU to allow CPU software to devise a subsequent countermeasure.

It will be understood that, during startup or running of the system, if required, the CPU or another master on the system bus may read content from the first NVM 11 via the system bus. In this case, the memory controller 10 of the present embodiment may perform an ECC and real-time repair process on the content read from the first NVM 11. As this process may be substantially the same as that of the first embodiment as shown in Figs. 7A to 7C, further description thereof is deemed unnecessary and omitted here.

The self-check module added in the memory controller of present embodiment can perform a self-check on the first NVM at an appropriate time (e.g., in an OTA upgrading phase, following a POR or system reset, during running of the system, etc.) according to settings in the option byte, which ensures reliability of the content of the first NVM, reduces errors in the first NVM that may arise out of interference from the outside world, increases correctness of content read by the CPU from the first NVM, reduces the number of times of ECC or error repairs with backup content from the second NVM performed on content from the first NVM, and accelerates and improves consistency of the system's operation.

It will also be understood that, during running of the system, a self-check may be performed before the system bus (i.e., the CPU or another master thereon) reads the first NVM. This can ensure reliability of the content of the first NVM, reduce errors in the first NVM that may arise out of interference from the outside world and increase correctness of content read by the CPU from the first NVM. Alternatively, a self-check may be performed simultaneously as, or after, the system bus (i.e., the CPU or another master thereon) reads the first NVM. This can ensure reliability of the content of the first NVM, reduce errors in the first NVM that may arise out of interference from the outside world and increase correctness of content read at a later time by the CPU from the first NVM.

### Embodiment 3

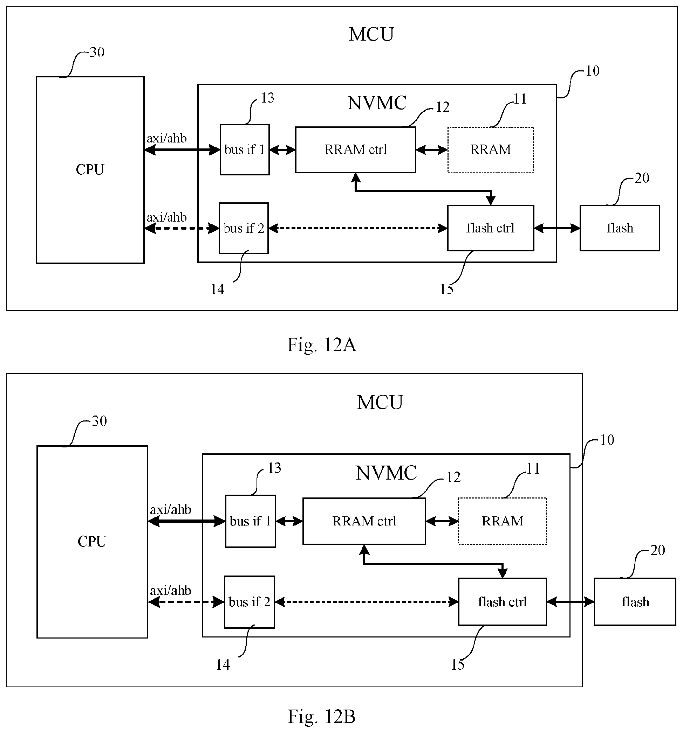

Referring to Figs. 12A and 12B, embodiments of the present invention also provide a microcontroller unit (MCU) chip including a central processing unit (CPU) 30 and the memory controller (NVMC) 10 as defined in any of the foregoing embodiments. The CPU 30 is coupled to the memory controller 10 via a system bus, in order to perform read and write operations on the first NVM 11 in the memory controller 10. The second NVM 20 is embedded in the MCU chip or (Fig. 12A) or the second NVM 20 is coupled to (Fig. 12B) the MCU chip. The second NVM 20 is coupled to the second memory controller 15 in the memory controller 10.

As this MCU chip employs the memory controller 10 of the present invention, it is much less likely to be interrupted due to errors in the content of the first NVM 11 during startup or running of the system. Moreover, the system has improved reliability and performance.

The description presented above is merely that of some preferred embodiments of the present invention and does not limit the scope thereof in any sense. Any and all changes and modifications made by those of ordinary skill in the art based on the above teachings fall within the scope as defined in the appended claims.

## Claims

1. A memory controller (10) coupled to a second non-volatile memory (NVM) (20), wherein the second NVM (20) comprises a first backup bank and a second backup bank, wherein one of the first and second backup banks is a default backup bank, and the other is an over the air (OTA) upgrade backup bank, and wherein the memory controller (10) comprises:
a first NVM (11), wherein the first NVM (11) allows faster read and write operations than the second NVM (20) and serves as a main memory for storing content that is necessary for operation of a system, and wherein content of the first NVM (11) has been backed up to the default backup bank of the second NVM (20);
a first memory controller (12) responsible for a read and write control of the first NVM (11); and
a second memory controller (15), wherein the second memory controller (15) is coupled to the first memory controller (12) and is configured to: in preparation for performing an OTA upgrade, program content of an OTA upgrade version into the OTA upgrade backup bank; after a power-on reset (POR) or a system reset and when detecting that the content of the OTA upgrade version in the OTA upgrade backup bank is valid, initiate an OTA upgrading phase and copy the content of the OTA upgrade version from the OTA upgrade backup bank to the first NVM (11), thereby completing the OTA upgrade; and when the copying succeeds, update the OTA upgrade backup bank as the default backup bank and update a previous default backup bank as the OTA upgrade backup bank for use of next OTA upgrade.

2. The memory controller (10) of claim 1, further comprising:
an OTA upgrade flag (fw_update) configured to indicate whether the content of the OTA upgrade version has been written to the OTA upgrade backup bank, if yes, the OTA upgrade flag (fw_update) is valid; and if not or after the content of the OTA upgrade version has been successfully copied from the OTA upgrade backup bank to the first NVM (11), the OTA upgrade flag (fw_update) is invalid; and/or
a backup bank mapping control flag (SWAP) configured to indicate which one of the first and second backup banks is designated as the default backup bank; and/or
an OTA upgrade success flag (ota_success) configured to indicate whether the OTA upgrade is successful.

3. The memory controller (10) of claim 2, further comprising an OTA upgrade check flag (ota_check) and/or an OTA upgrade failure flag (ota_fail), wherein the OTA upgrade check flag (ota_check) is configured to indicate whether to perform a self-check in the OTA upgrading phase on the content of the OTA upgrade version that has been copied to the first NVM (11), and wherein the OTA upgrade failure flag (ota_fail) is opposite or complementary to the OTA upgrade success flag (ota_success) and is configured to be used with the OTA upgrade success flag (ota_success) to indicate success or failure of the OTA upgrade.

4. The memory controller (10) of claim 3, wherein the OTA upgrade flag (fw_update), the backup bank mapping control flag (SWAP) and the OTA upgrade check flag (ota_check) are provided in an option byte (Opt) or a control register (161) and do not lose data in an event of a power loss, and wherein the OTA upgrade failure flag (ota_fail) and the OTA upgrade success flag (ota_success) are provided in an ordinary control register and lose data in an event of a power loss.

5. The memory controller (10) of any one of claims 1 to 4, further comprising:
a first bus interface (13), wherein the first bus interface (13) is coupled to the first memory controller (12) and a system bus and is configured for transfer of content between the system bus and the first memory controller (12),
wherein the second memory controller (15) is further configured to, when out of the OTA upgrading phase, cooperate with the first memory controller (12) to back up the content in the first NVM (11) to the default backup bank, and wherein when an error is identified in content read from the first NVM (11), the second memory controller (15) is further configured to read corresponding backup content from the default backup bank and transmit the corresponding backup content to the system bus or write the corresponding backup content to the first NVM (11) for content repair.

6. The memory controller (10) of claim 5, wherein the second NVM (20) has a plurality of default backup banks each storing backup content of a corresponding old version, wherein the second memory controller (15) is further configured to, when the OTA upgrade fails, copy the backup content of a corresponding old version stored in a designated one of the default backup banks to the first NVM (11) according to a rollback command issued in response to the failure of the OTA upgrade, or wherein the second NVM (20) has another bank, wherein the first and second backup banks are configured to store backup content of respective versions, and wherein the another bank is configured to store other data than in the first NVM (11); or
wherein the memory controller (10) further comprises a second bus interface (14), wherein the second bus interface (14) is coupled to the second memory controller (15) and the system bus and is configured to, when out of the OTA upgrading phase, transmit backup content read by the second memory controller (15) from the default backup bank to the system bus; or
wherein the memory controller (10) further comprises a control register (161) coupled to the first memory controller (12), wherein the first memory controller (12) is further configured to read and load an option byte (Opt) into the control register (161) following a system reset, thereby validating the option byte (Opt),
wherein the option byte (Opt) is a special memory region in the first or second NVM (11,20) and is configured to store configuration information.

7. The memory controller (10) of claim 6, wherein the first memory controller (12) comprises a first soft error correction module (121), and wherein in case of being out of the OTA upgrading phase, when the system bus reads corresponding content from the first NVM (11), the first soft error correction module (121) performs an error checking on the corresponding content in real time through an error checking and correction (ECC) function,
wherein: when the configuration information pre-configures that the first NVM (11) is not to be repaired, the first soft error correction module (121) is further configured to correct the error through the ECC function and to provide corrected content to the system bus when the error is detected by the ECC function and meets an error correction ability of the first soft error correction module (121); or
regardless of whether the configuration information pre-configures that the first NVM (11) is to be repaired or not, the first soft error correction module (121) is configured to correct the error through the ECC function and to provide corrected content to the system bus when the error is detected by the ECC function and meets the error correction ability of the first soft error correction module (121), and wherein when the memory controller (10) becomes idle at a later time, the second memory controller (15) is configured to read corresponding backup content from the default backup bank and to write the backup content to the first NVM (11) for content repair.

8. The memory controller (10) of claim 7, wherein the first soft error correction module (121) is further configured to, during writing of content to the first NVM (11) and/or during backing up of content in the first NVM (11) to the default backup bank, generate a corresponding error checking and correction (ECC) code (202), wherein the corresponding ECC code (202) is stored in the default backup bank along with the content in the first NVM, or
the second memory controller (15) further comprises a second soft error correction module (151) that is configured to, during backing up of content in the first NVM (11) to the default backup bank, generate a corresponding ECC code (202), wherein the corresponding ECC code (202) is stored in the default backup bank along with the content in the first NVM,
wherein when the system bus reads the content in the first NVM (11), the first soft error correction module (121) carries out an error checking on read content in real time through the ECC function using corresponding ECC code (202).

9. The memory controller (10) of claim 7, wherein when the first soft error correction module (121) detects that the error detected by the ECC function still exists or exceeds the error correction ability of the first soft error correction module (121), and if the configuration information configures that the first NVM (11) is to be repaired, the second memory controller (15) is further configured to read backup content from the default backup bank and to write the read content to the first NVM (11) through the first memory controller (12) for content repair.

10. The memory controller (10) of claim 9, wherein when out of the OTA upgrading phase, the second memory controller (15) reads backup content in the default backup bank in a unit of a single address, or a single row address, or a single block of the NVM (11) according to the configuration information and writes the backup content to the first NVM (11) through the first memory controller (12) for content repair of the first NVM (11).

11. The memory controller (10) of any one of claims 7 to 10, further comprising a status register (162) configured to record: first status information about an result of the ECC function performed on the first NVM (11) when the configuration information configures that the first NVM (11) is not to be repaired; and second status information about an result of repair performed on the first NVM (11) when the configuration information configures that the first NVM (11) is to be repaired, wherein the first status information contains statuses and addresses of errors, and wherein the second status information contains at least one of statuses, addresses and a number of repair-failed errors and a number of repair failures.

12. The memory controller (10) of claim 11, wherein when out of the OTA upgrading phase, the first or second memory controller (11,12) is further configured to record the addresses of the repair-failed errors in the first NVM (11) in the status register (162), and wherein a software strategy determines whether to store the addresses of the repair-failed errors in the first NVM (11) as damaged addresses in the configuration information of the option byte (Opt),
optionally wherein when out of the OTA upgrading phase, the second memory controller (15) is further configured to automatically skip the first NVM (11), to read corresponding backup content from the default backup bank and to return the corresponding backup content to the system bus, upon the system bus reading a corrupted address in the configuration information and/or an error address recorded in the status register (162).

13. The memory controller (10) of claim 11, wherein the status register (162) is further configured to generate an interrupt based on a record stored in the status register (162).

14. The memory controller (10) of claim 1, wherein the first memory controller (12) further comprises a self-check module (123), wherein in preparation for performing the OTA upgrade and after the content of the OTA upgrade version is copied from the OTA upgrade backup bank to the first NVM (11), the self-check module (123) is configured to perform a self-check on the content that is copied into the first NVM (11) by reading and comparing the content in the first NVM (11) with the content in the OTA upgrade backup bank, wherein if no difference is found in the comparison, the content in the first NVM (11) is considered to be correct, or if a difference is identified in the comparison, the content in the first NVM (11) is considered to contain an error; or
wherein the first NVM (11) is an embedded memory that does not require erasure before a write operation to be performed thereon, and the second NVM (20) is off-chip memory,
optionally wherein the first NVM (11) comprises at least one of ferroelectric random-access memory (FeRAM), magnetic random-access memory (MRAM), resistive random-access memory (RRAM) and phase-change memory (PCM), and/or wherein the second NVM (20) comprises flash memory.

15. A microcontroller unit (MCU) chip, comprising a central processing unit (CPU) and the memory controller (10) of any one of claims 1 to 14, wherein the CPU is coupled to the memory controller via a system bus in order to perform read and write operations on the first NVM (11) in the memory controller (10), wherein the second NVM (20) is built in or externally connected to the MCU chip, and is coupled to the second memory controller (15) in the memory controller (10).
